# EUROPEAN PATENT SPECIFICATION

(11) **EP 2 924 864 B1**
(45) Date of publication and mention of the grant of the patent: **01.11.2017**
(21) Application number: 14162353.8
(22) Date of filing: 28.03.2014
(51) Int. Cl.: H02M 5/293, G01R 19/175, H05B 33/08

(54) **A zero-current detection circuit**
Nullstromdetektionsschaltung
Circuit de détection de courant nul

(43) Date of publication of application: 30.09.2015
(73) Proprietor: Helvar Oy Ab, 02150 Espoo (FI)
(72) Inventor: Dominey, John, DARTFORD, Kent DA2 7SY (GB)
(74) Representative: Berggren Oy, Helsinki & Oulu

(56) References cited:
- WO-A1-00/52813
- DE-A1- 19 642 871

## Description

### FIELD OF THE INVENTION

The example embodiments of the present invention relate to zero-current detection, for example, in context of controlling light intensity level of a dimmable light source.

### BACKGROUND OF THE INVENTION

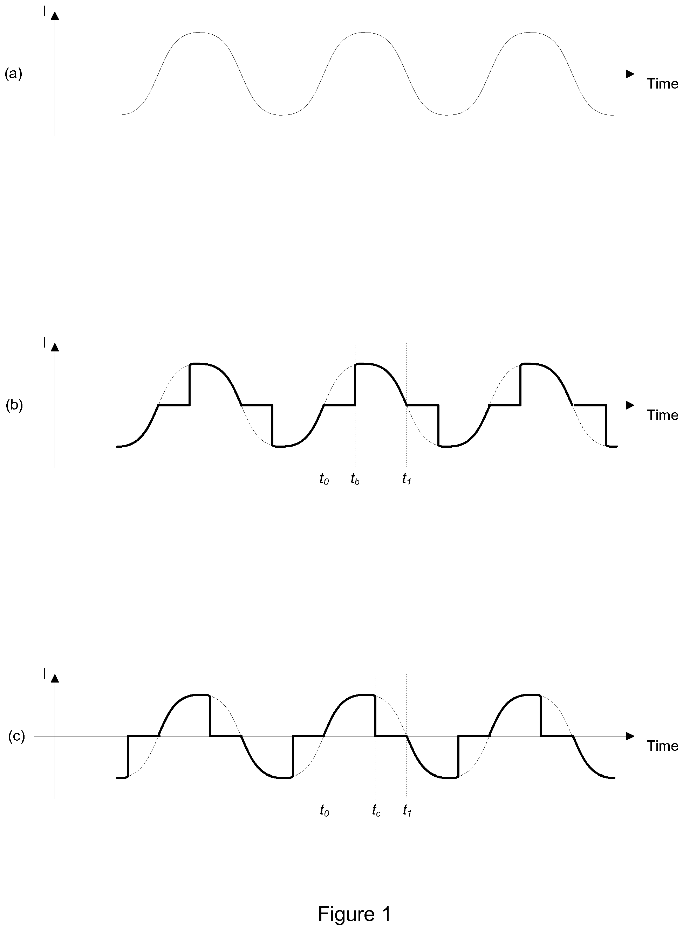

The AC electrical power supplied to a load can be reduced by cutting off a part of each half cycle of alternating current. This approach provides a convenient way to adjust the light intensity level of an incandescent lamp. Such cutting of portions of half cycles is called phase-cutting and it can be done in the so-called "leading edge" or "trailing edge" mode. Phase-cutting in the leading edge mode means that the current is turned on somewhere in the middle of an alternating current (AC) half-wave, and it is allowed to flow until the end of the AC half-wave, i.e. until the current reaches a zero value between the half-waves. In a corresponding way, phase-cutting in the trailing edge mode means that the current is allowed to flow from the very beginning of a AC half-wave, but it is cut off before the AC half-wave has come to an end. Figure 1, which will be described in more detail later in this text, illustrates the concept of phase-cutting of the "leading edge" and "trailing edge" types.

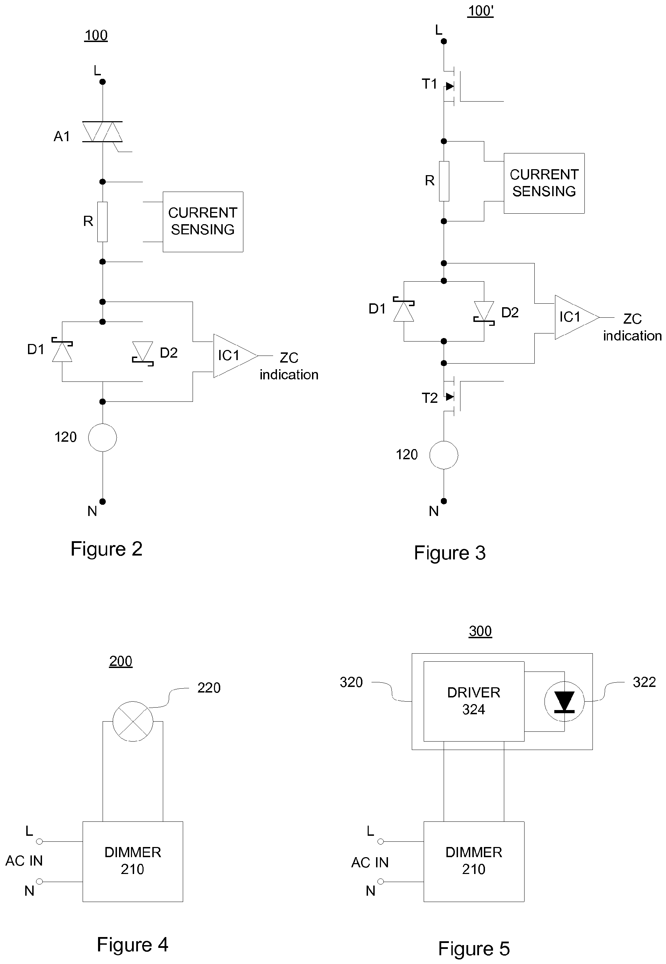

Applying a phase-cut AC current to provide dimming of light can be referred to as phase-cut dimming. The phase-cutting dimming is typically implemented in a dimmer device that control provision of the operating power (typically from the mains electricity) to the load, e.g. a luminaire hosting one or more dimmable light sources. Traditionally, the "leading edge" type phase-cut dimming has been implemented with a triac (i.e. a triode for alternating current), wherein the triac and the load are connected in series between the terminals providing the AC supply. An example of such a circuit is depicted in Figure 2, illustrating a circuit 100 comprising a current path between AC supply nodes L and N with the triac A1 and a load 120. The load 120 may comprise e.g. a dimmable light source. The circuit 100 includes also further components that will be described later in this text. In the beginning of a half-wave the triac A1 is kept in non-conductive state. A triggering signal is given to the triac A1 at a desired moment during the half-wave. Consequently, the triac A1 begins to conduct, and current flows through the load 120 for the remaining part of the half-wave. At the end of the half-wave the current through the triac A1 drops below the threshold current and the triac A1 returns into non-conducting state and remains in the non-conductive state until it is triggered again at the desired point in the next half-wave.

An alternative known solution applies switches such as metal-oxide-semiconductor field-effect transistors (MOSFETs) instead of the triac to implement the "leading edge" type phase-cutting. Usage of e.g. MOSFETs instead of the triac A1 is advantageous in that MOSFETS cause lower power losses when applied as switch components and they are also more accurately controllable than the triac A1. Figure 3 provides an example in this regard, illustrating a circuit 100' where a pair of MOSFETs T1 and T2 is arranged in series with the load 120 in the current path between the AC supply nodes N and L. One of the MOSFETs T1, T2 is switched on (i.e. the switch is closed) in turn at a desired point of time during a half-wave. The switching of MOSFETs T1, T2 take turns such that, conceptually, the MOSFET T1 is switched during odd-numbered half-waves (e.g. during ones during which the electric current flows toward the node N) and the MOSFET T2 is switched during even-numbered half-waves (e.g. during ones during which the electric current flows toward the node L). During those half-waves when the MOSFET T1, T2 is not operating as a switch it allows the electric current to pass through via its body diode. As a consequence of such switching, "leading edge" type phase-cut AC is supplied to the incandescent lamp 120.

Current sensing can be used e.g. to monitor the correct operation of the circuit. Additionally, in order to enable correct timing for switching of the triac A1 or the MOSFETs T1, T2, the moment of the electric current through the circuit 100, 100' reaching zero between adjacent half-waves of the AC needs to be detected. For the former purpose a resistor R (or, for example, a current transformer) may applied. For the latter purpose, the circuit 100, 100' comprises Schottky diodes D1 and D2 connected in parallel in reverse directions (i.e. connected "back to back"). Each of the Schottky diodes D1, D2 conducts during the respective half-wave of the AC, as defined by the polarity of the Schottky diode D1, D2. For example, when the Schottky diode D2 is approaching the end of a conduction period, at a certain moment (during the half-wave) the voltage across the Schottky diode D2 drops below the threshold voltage, wherein the current flow through the Schottky diode D2 ceases fairly quickly. This relatively rapid change in the current is detected by the differential amplifier IC1, output of which forms a zero current indication signal.

The zero current detection arrangement based on the Schottky diodes D1, D2 has the disadvantage that, although Schottky diodes D1 and D2 cause relatively low losses at low load currents, at higher currents in the order of a few amperes, such as six amperes, rather significant losses begin to occur, which may result in the Schottky diodes D1 and D2 beginning to heat up. While the losses in the circuit are an disadvantage as such, additional burden is the fact that Schottky diodes that can tolerate a high forward direction current, and hence can stand the unwanted but inevitable heat buildup, without breaking apart are typically relatively expensive. The heat generated in the Schottky diodes D1 and D2 may also have adverse effects on the operation of other components of the circuit. WO-A-00/52813 discloses an alternative solution, where the phase-dimmer and the zero-current detection are integrated into one single device.

### SUMMARY OF THE INVENTION

It is an object of the present invention to provide a technique that enables accurate, energy-efficient and reliable zero-current detection in a circuit that is arranged to generate "leading edge" type phase-cut AC for a load, in particular to a load that comprises a dimmable light source.

The object(s) of the invention are reached by a circuit and by a lighting arrangement as defined by the respective claims.

According to a first example embodiment, a circuit for providing a leading edge type phase-cut alternating current (AC) to a load is provided. The circuit comprises a current path for coupling a load to an input AC supply, at least one primary switch arranged in said current path for implementing leading edge type phase-cutting of the input AC, the at least one primary switch arranged to operate alternatingly in one of a conductive and a non-conductive state in accordance with at least one first control signal, and a detection circuit arranged in said current path, arranged to provide a zero current detection signal for indicating the end of a half-wave in said phase-cut AC. The detection circuit comprises two parallel branches and a first MOSFET arranged in a first branch of said two parallel branches and a second MOSFET in a second branch of said two parallel branches such that the direction of the current path from the source to the drain through the first MOSFET is opposite to that of the second MOSFET, wherein one or both of the first MOSFET and the second MOSFET are arranged to receive respective second control signals for switching into one of a conductive state and a non-conductive state.

According to a second example embodiment, a lighting arrangement is provided. The lighting arrangement comprises a circuit according to the first example embodiment and a lighting device comprising one or more light emitting diodes arranged to operate as said dimmable light source.

The exemplifying embodiments of the invention presented in this patent application are not to be interpreted to pose limitations to the applicability of the appended claims. The verb "to comprise" and its derivatives are used in this patent application as an open limitation that does not exclude the existence of also unrecited features. The features described hereinafter are mutually freely combinable unless explicitly stated otherwise.

The novel features which are considered as characteristic of the invention are set forth in particular in the appended claims. The invention itself, however, both as to its construction and its method of operation, together with additional objects and advantages thereof, will be best understood from the following detailed description of specific embodiments when read in connection with the accompanying drawings.

### BRIEF DESCRIPTION OF THE DRAWINGS

Figure 1 illustrates the concept of phase-cutting.
Figure 2 schematically illustrates provision of phase-cut alternating current (AC) to a load.
Figure 3 schematically illustrates provision of phase-cut AC to a load.
Figure 4 schematically illustrates an arrangement for providing dimmable lighting on basis of phase-cut AC according to an example embodiment.
Figure 5 schematically illustrates an arrangement for providing dimmable lighting on basis of phase-cut AC according to an example embodiment.
Figures 6a and 6b illustrate respective examples of a temporally misaligned phase-cut half-wave of AC.
Figure 7 schematically illustrates some components of a circuit arrangement according to an example embodiment.
Figure 8 depicts an example of timing of control signals for operating switches of a circuit arrangement according to an example embodiment.
Figure 9 schematically illustrates some components of a circuit arrangement according to an example embodiment.

### DETAILED DESCRIPTION

Figure 1 illustrates the concept of phase-cutting referred to in the foregoing. Diagram (a) depicts a segment of alternating current (AC) exhibiting (or approximating) a sinusoidal periodical variation of the current level as a function of time.

A bold solid curve in diagram (b) depicts the corresponding segment of AC with "leading edge" phase-cutting, whereas a thin dashed curve in diagram (b) depicts the corresponding "uncut" AC approximating the sinusoidal waveform. As illustrated in the example of diagram (b), in the "leading edge" phase-cutting the leading part of each half-wave from time *t₀* to time *t_{b}* is cut off whereas the remaining part of each half-wave from time *t_{b}* to time *t₁* follows the waveform of the respective "uncut" half-wave of the AC. In this example, the cut-off part in the beginning of each half-wave from time *t₀* to time *t_{b}* has duration *T_{off_le},* whereas the duration of the "uncut" half-wave time *t₀* to time *t₁* is *T*_{hf}, thereby leaving the active part in the end of each half-wave time *t_{b}* to time *t₁* with duration *T_{on_le}* = *T_{hf} - T_{off_le}.*

A bold solid curve in diagram (c) depicts the corresponding segment of AC with "trailing edge" phase-cutting, whereas a thin dashed curve in diagram (c) depicts the corresponding "uncut" AC approximating the sinusoidal waveform. As illustrated inn the example of diagram (c), in the "trailing edge" phase-cutting the leading part of each half-wave from time *t₀* to time *t_{c}* follows the form of the respective "uncut" half-wave of the AC, whereas the trailing part of each half-wave from time *t_{c}* to time *t₁* is cut off. In this example, the cut-off part in the end of each half-wave from time *t₀* to time *t_{c}* has duration *T_{off_te}*, whereas the duration of the "uncut" half-wave from time *t₀* to time *t₁* is *T*_{hf}, thereby leaving the active part in the beginning of each half-wave from time *t₀* to time *t_{c}* with duration *T_{on_te}* = *T_{hf} - T_{off_te}.*

The phase-cut AC may be applied for dimming of a dimmable light source. Applying a phase-cut AC current to provide dimming of light can be referred to as phase-cut dimming. The phase-cutting dimming is typically implemented in a dimmer device that controls provision of the operating power (typically from the mains electricity) to the load, e.g. a luminaire hosting one or more dimmable light sources.

In this regard, e.g. the circuits 100 and 100' may be applied, for example, in context of lighting arrangements 200 and 300 schematically illustrated in Figures 4 and 5. In these examples, the load is provided as or within a lighting device 220, 320 whereas the components of the circuit 100, 100' apart from the load 120 are provided in a dimmer device 210 that may be a standalone dimmer for one dimmable lighting device or constitute one output of a multichannel lighting controller.

Typically, the duration of the time period *T_{on_le}* or *T*_{*on*_*te*} has been selected such that each half-wave carries a desired fraction of the energy in comparison to the energy carried by an "uncut" half-wave in order to operate an incandescent lamp with the corresponding fraction of the nominal (or maximum) light intensity. Figure 4 schematically illustrates the exemplifying lighting arrangement 200 for providing dimmable lighting on basis of phase-cut AC. In Figure 4, the operating energy is provided to the dimmer device 210 via an operating power input "AC IN". The operating power may be obtained e.g. from the mains electricity and e.g. 230 V AC at 50 Hz may be used. The dimmer device 210 may be arranged to apply phase-cut dimming based on e.g. the "leading edge" or the "trailing edge" phase-cutting and to supply the phase-cut AC as the operating power to an incandescent lamp 220 serving as the load 120. The extent of phase-cutting (e.g. the duration of the time period *T_{off_le}* or *T_{off_te}*) is (indirectly) selectable by a user via a user interface of the dimmer device 210, e.g. by operating a rotatable knob, a sliding knob or push-buttons arranged as the user-interface of the dimmer device e.g. in a housing of the dimmer device 210. Consequently, the extent of phase cutting may be varied over time and hence varied from one half-wave to another.

Figure 5 schematically depicts the lighting arrangement 300 for providing dimmable lighting using the dimmer device 210 together with a dimmable light source. In Figure 5, the dimmer device 210 is arranged to supply a lighting device 320 serving as the load 120. The lighting device 320 makes use of one or more light emitting diodes (LEDs) 322 as the light source. In addition to the LEDs 322, the lighting device 320 further comprises a LED driver 324 arranged to convert the operating power suitable for driving the LEDs 322 in a desired manner. The lighting device 320 may be provided e.g. as a retrofit LED bulb that provides the same mechanical interface as a traditional incandescent light bulb while providing a similar light output at a significantly reduced energy consumption. Alternatively the lighting device 320 may be provided e.g. as a luminaire that comprises a driver portion that acts as an interface between control units (such as the dimming device 110) and the LED light sources.

The efficiency of the LEDs 322 is much higher than that of the incandescent lamp 220, and hence in comparison to the incandescent lamp 220 the LEDs 322 require only a fraction of the energy - which can be derived on basis of a fraction of the active part of the phase-cut half-wave provided in the phase-cut AC supplied from the dimmer device 210. Consequently, the lighting device 320 may employ only a fraction from each (possibly phase-cut) half-wave in generation the light output from the LEDs 322. However, the LED driver 324 is typically arranged to apply the duration of the remaining active period *T_{on_le}* or *T_{on_te}* in a phase-cut half-wave in relation to the overall duration of an "uncut" half-wave *T_{hf}*, i.e. *T_{on_le}* / *T_{hf}* or *T_{on_te}* / *T_{hf}*, as an indicator of the desired light output level.

The following description concentrates on details of the "leading edge" type phase-cut dimming applied, for example, in the framework of the lighting arrangement 200 or the lighting arrangement 300 where the dimmer device 210 is based on the circuit 100' or its variation and is arranged to supply a lighting device comprising a dimmable light source. However, the description generalizes in application of the "leading edge" type phase-cutting to any load that may benefit from accurate control of the phase-cut AC supplied thereto.

In order to supply "leading edge" type phase-cut AC resulting in a desired light intensity level, it is advantageous to carry out the detection of zero-current points between half-waves of the AC supplied as the input power in a reliable and accurate manner. In case the zero-current points between the half-waves are not properly identified, even the most accurate timing of the rising edge (time *t_{b}*) in a phase-cut half-wave in relation to the beginning of the starting time *to* of the half-wave is rendered useless in case the starting time *t₀,* i.e. the reference point for defining the timing of the rising edge as *t_{b}* = *t₀* + *T_{off_le}*, is not correctly detected. In particular, incorrect determination of the zero-current point *t₀* used as basis for timing of a rising edge of a phase-cut half-wave appearing in a high-energy portion of an "uncut" half-wave may significantly change the amount of energy and/or duration of the active period of the phase-cut half-wave supplied to the load 120, and hence e.g. to cause the lighting device 220, 320 to provide a light intensity level that is higher or lower than the desired one.

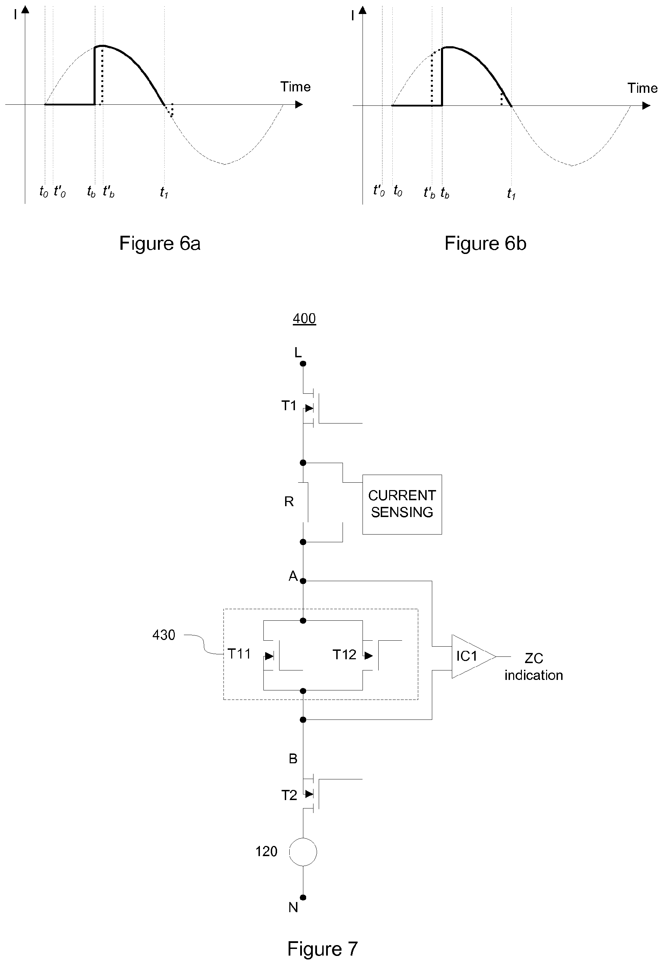

The phenomenon is illustrated for a single half-wave in Figure 6a, showing the "uncut" half-wave as a regular dashed curve, the desired phase-cut half-wave commencing at time *t_{b}* as a solid bold curve and a phase-cut half-wave that is commenced at time *t'_{b}* = *t'₀* + *T_{off_le}* where *t'₀* is a belated estimate of the time *t₀* as a bold dotted curve. In this scenario, the resulting phase-cut half-wave is time shifted later in time with a high-energy portion in the beginning of the desired phase-cut half-wave omitted. Figure 6b, in turn, depicts the "uncut" half-wave as a regular dashed curve, the desired phase-cut half-wave commencing at time *t_{b}* as a solid bold curve and a phase-cut half-wave that is commenced at time *t'_{b}* = *t'₀* + *T_{off_le}* where *t'₀* is an early estimate of the time *t₀* as a bold dotted curve. In this scenario, the resulting phase-cut half-wave is time shifted earlier in time, thereby introducing an unwanted high-energy portion in the beginning of the resulting phase-cut half-wave.

Figure 7 schematically illustrates at least some components of a circuit arrangement 400 comprising a detection circuit 430 that may be used to facilitate reliable and accurate detection of the zero current points between the half-waves of the alternating current flowing through the circuit arrangement 400. The detection circuit 430 is arranged the replace the Schottky diodes D1 and D2 of e.g. the circuits 100 and 100' and is hence applicable in context of the circuit 100, in context of the circuit 100' and/or in context a corresponding circuit arranged to supply power the load 120. In the exemplifying circuit of Figure 7, the detection circuit 430 is arranged in a circuit with MOSFETs like in circuit 100' earlier and, hence, in the following the structure and operation of the detection circuit 430 are described with references to some components of the circuit 100' in an illustrative and non-limiting manner.

In the circuit arrangement 400, the pair of MOSFETs T1 and T2 is arranged in series with the load 120 in the current path between the AC supply nodes N and L. The MOSFETs T1 and T2 may be referred to as primary switches or primary MOSFETS that are applicable for implementing the phase-cutting, for example "leading edge" type phase-cutting of the input AC. The detection circuit 430 is arranged in the current path between the nodes N and L. The detection circuit 430 comprises two parallel current paths or branches, which in the example of Figure 7 are arranged to connect a node A and a node B within the current path between the nodes N and L.

In a practical phase-cutting dimmer application the load 120 is typically changeable, and/or the load 120 is physically located at a certain distance from the other components illustrated in Figure 7. Consequently the circuit arrangement 400 could comprise distinct coupling nodes on both sides of the load 120, which coupling nodes would constitute an output of the circuit arrangement 400 for coupling a load thereto. Also, such two-node output coupling to the load could be located elsewhere along the current path between the nodes L and N than between the second primary MOSFET 120 and the node N. The current path between the nodes L and N in Figure 7 would then appear as two sub-paths, one between the node L and the first output coupling node and the other between the second output coupling node and the node N. In general it can be said that the circuit arrangement 400 comprises a current path for coupling a load to an input AC supply.

In the detection circuit 430 a first MOSFET T11 is arranged in a first current path (or in a first branch) and a second MOSFET T12 is arranged in a second current path (or in a second branch) of the detection circuit 430. The first MOSFET T11 is arranged in the first branch such that its source is coupled to the node B and its drain is coupled to the node A, whereas the second MOSFET T12 is arranged in the second branch such that its source is coupled to the node A and its drain is coupled to the node B. Such arrangement of the MOSFETs T11 and T12 implies that the source of the MOSFET T11 is coupled to the drain of the MOSFET T12 and the source of the MOSFET T12 is coupled to the drain of the MOSFET T11. In other words, the MOSFETs T11 and T12 are coupled "back-to-back" such that the direction of the current path from the source to the drain through the first MOSFET T11 is opposite to that of the second MOSFET T12. In the detection circuit 430 both MOSFETs T11, T12 are arranged for switching into one of a conductive state and a non-conductive state in accordance with a respective second control signal, which may be the same control signal for both or a separate control signal for each of the MOSFETs T11, T12.

When operating the circuit of Figure 7, one of the primary MOSFETs T1, T2 is switched on (i.e. the switch is closed) in turn at a desired point of time during a half-wave of the input AC. The switching of MOSFETs T1, T2 takes turns such that, conceptually, the primary MOSFET T1 is switched during odd-numbered half-waves (e.g. during ones during which the electric current flows toward the node N) and the MOSFET T2 is switched during even-numbered half-waves (e.g. during ones during which the electric current flows toward the node L). During those half-waves when the primary MOSFET T1, T2 is not operating as a switch it is arranged to allow the electric current to pass through via its body diode. As a consequence of such switching, "leading edge" type phase-cut AC is supplied to the load 120.

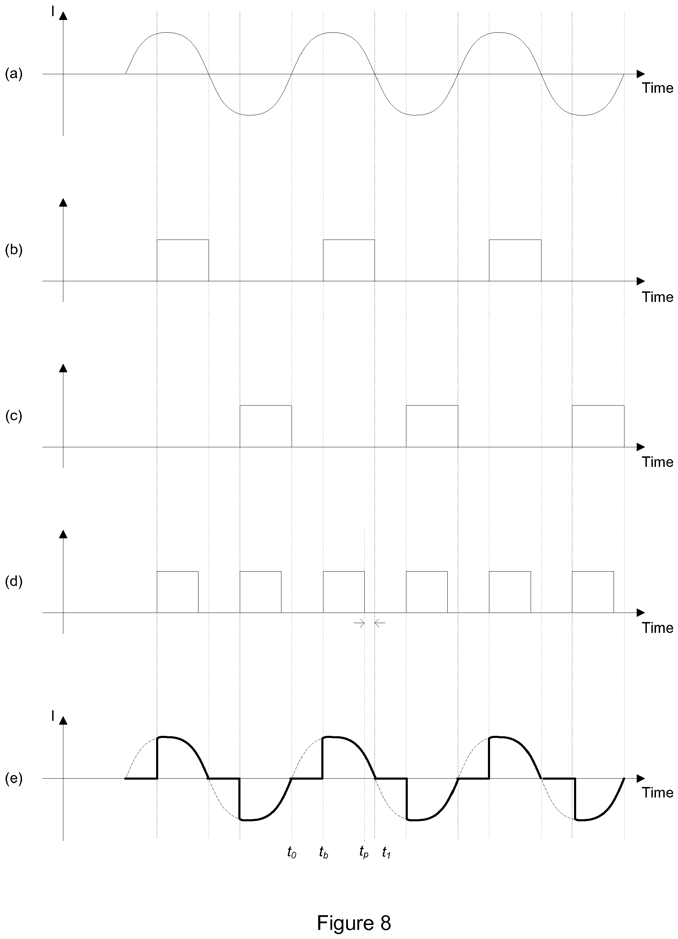

The timing of control signals is depicted in Figure 8. The curve (a) therein depicts the alternating current that would flow between the nodes N and L if no phase-cutting was applied. The curve (b) depicts the timing of a first control signal for switching the first primary MOSFET T1 into one of a conductive and a non-conductive state (i.e. enabling and disabling the flow of electric current therethrough) in relation to timing of half-waves of the input AC. The high value of the curve (b) indicates the time period during which the first primary MOSFET T1 is set/kept in a conductive state to enable flow of electric current therethrough (in both directions between its source and its drain), whereas the low value of the curve (b) indicates the time period during which the first primary MOSFET T1 is set/kept in a non-conductive state to disable flow of electric current therethrough (and hence the electric current can flow only via the body diode of the first primary MOSFET T1 from its source to its drain).

The curve (c) depicts the timing of a first control signal for switching the second primary MOSFET T2 into one of the conductive and the non-conductive state (i.e. enabling and disabling the flow of electric current therethrough) in relation to timing of half-waves of the input AC. The high value of the curve (c) indicates the time period during which the second primary MOSFET T2 is set/kept in a conductive state to enable flow of electric current therethrough (in both directions between its source and its drain), whereas the low value of the curve (c) indicates the time period during which the second primary MOSFET T2 is set/kept in a non-conductive state to disable flow of electric current therethrough (and hence the electric current can flow only via the body diode of the second primary MOSFET T2 from its source to its drain).

The curve (d) depicts the timing of the second control signals for switching the MOSFETS T11 and T12 of the detection circuit 430 into one of the conductive state and the non-conductive state in relation to the switching of the primary MOSFETs T1 and T2 (and hence in relation to timing of half-waves of the input AC). The high value of the curve (d) indicates the time period during which the MOSFETs T11 and T12 are set/kept in the conductive state to enable flow of electric current therethrough (in both directions between the source and the drain of the respective MOSFET T11, T12), whereas the low value of the curve (d) indicates the time period during which the MOSFETs T11 and T12 are set/kept in the non-conductive state to disable flow of electric current therethrough (and hence the electric current can flow only via the body diode of the respective MOSFET T12, T12 from its source to its drain).

As the curve (d) indicates, the second control signal is changed to the enabling state that causes switching the MOSFETs T11 and T12 into the conductive state at the same time or essentially at the same time as either of the first control signals is (in curves (b) and (c)) is changed to the enabling state to cause switching the respective primary MOSFET T1, T2 into the conductive state. In contrast, the second control signal is changed to the disabling state that causes switching the MOSFETs T11 and T12 into the non-conductive state by a predefined margin before the end of the respective half-wave of the alternating current that flows through the circuit arrangement.

The timing of the control signals is described in more detail for the third half-wave (i.e. the second half-wave for which the current level *l* is above the time axis) in more detail. Similar operation applies to all half-waves for which the current level *l* is above the time axis. Time *t₀* indicates the beginning of the half-wave, whereas the time *t_{b}* indicates the point of time within the respective half-wave for switching the MOSFETS T1, T11 and T12 into the conductive state. In other words, the MOSFETS T1, T11 and T12 are switched into the conductive state after a period of *T_{off_le}* = *t_{b} - t₀* from the beginning of the half-wave indicated by time *to.* The first primary MOSFET T1 is switched into the non-conductive state at time *t₁* indicated the end of the respective half-wave. The MOSFETs T11 and T12 are switched into the non-conductive state at time *tₚ*, indicating the point of time that is by a predefined margin *tₘ* = *t₁ - tₚ* before the end of the respective half-wave of the alternating current that flows through the circuit arrangement 400.

For the immediately following half-wave of the input AC (as well as for other half-waves of the input AC for which the current level *l* is below the time axis), the second primary MOSFET T2 is switched between the conductive and non-conductive states in a manner similar to described above for the third half-wave of Figure 8 (as well as for other half-waves of the input AC for which the current level *l* is above the time axis), while the switching of the MOSFETS T11 and T12 follows the switching pattern of the second primary MOSFET T2 in manner similar to one described above in case of the for the first primary MOSFET T1.

The period *T_{off_le}* in the beginning of a half-wave, and hence the timing of *t_{b}* within the half-wave, depends on the currently applied light intensity level (e.g. the dimming level). The time *tₚ* may be defined as a moment of time after a predetermined (dimming level dependent) period of time after the time *t_{b}.* Advantageously, though, the time *tₚ* may be defined as time when the absolute value of the input AC voltage decreases to be smaller than or equal to a predetermined reference voltage. In other words, the MOSFETs T11 and T12 are switched into the non-conductive state in response to detecting a voltage between the nodes L and N to have an absolute value that is smaller than or equal to the reference voltage. The reference voltage may be zero or it may be a small non-zero voltage. Since the load 120 typically exhibits at least some inductance, the current via the circuit arrangement 400 reaches zero a short period of time after the voltage across the input AC nodes N and L reaches zero voltage, and the time period therebetween may be applied as the time margin *tₘ.*

Consequently, due to the impedance of the load 120, small electric current flows through the MOSFETs T11 and T12 during the time margin *tₘ* immediately preceding the end of a half-wave of the alternating current that flows through the circuit arrangement 400. This current is used in the zero current detection by the differential amplifier IC1. This electric current flows through the body diode of either the MOSFET T11 or the MOSFET T12, depending on which of the differently polarized two half-waves was just approaching its end. The body diode of the MOSFET T11 or T12 operates for the (short) time period *tₘ* so that the remaining current caused by the inductance in the load 120 flows through the body diode until it ceases abruptly at the end of the half wave. This abrupt change is detected by the differential amplifier IC1, which, consequently, generates the zero-current indication.

An advantage of such operation e.g. in comparison to the circuits 100 and 100' is that since for a majority of the period of each half-wave of the phase-cut AC the electric current flows through the switched-on MOSFETs T11 and T12, the power loss is significantly smaller than in case of running the current via the pair of Schottky diodes D1 and D2. Moreover, only for a very short period at the end of each half-wave the electric current needs to flow through the body diode of the MOSFET T11, T12, during which the voltage across (the body diode of) the MOSFET T11, T12 is already approaching zero anyway, the momentary value of the current is likewise small, and hence the resulting power losses are minimal in comparison to the Schottky diode based approach. As an additional benefit, MOSFETs are typically also cheaper than Schottky diodes of the same power rating, suggesting that the detection circuit 430 further reduces the manufacturing cost of a device making use of the circuit arrangement 400 in comparison to using the Schottky diode based approach.

The first control signals for switching the primary MOSFETS T1 and T2 between the conductive and non-conductive states and the second control signals for switching the MOSFETs T11 and T12 of the detection circuit 430 may be issued by a control portion or control entity coupled to the circuit arrangement 400 or provided as part of the circuit arrangement 400. The control portion/entity may be provided by hardware means, by software means or by a combination of hardware and software means. As an example the control portion/entity may be provided as a processor (as a microprocessor, as a microcontroller, etc.) arranged to issue the first and second control signals according to timing described in the foregoing. The control portion may be arranged to receive the zero current indication from the differential amplifier IC1 and to receive an indication of the voltage across the input AC nodes N and L. Instead of receiving the voltage indication, the control portion may be equipped with voltage measurement means and/or with zero-voltage detection (ZVD) means for detection of the zero-voltage point between the half-waves of the input AC. The indications regarding the (points of time of) zero current and zero voltage enable the control portion to time the switching of the MOSFETS T1, T2, T11 and T12 at the end of the half-waves of the input AC.

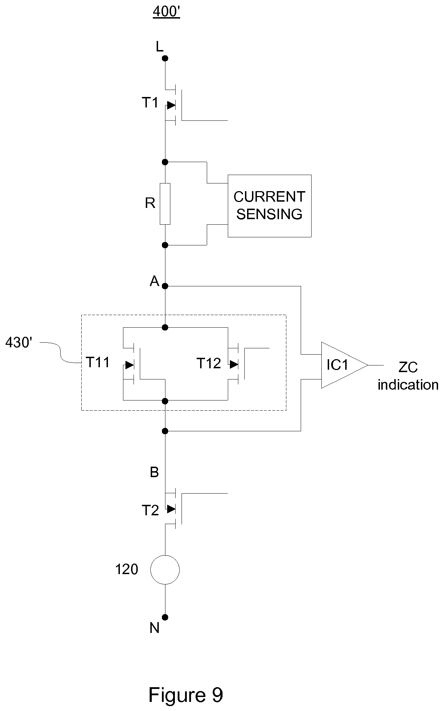

Figure 9 schematically illustrates at least some components of a circuit arrangement 400' comprising a detection circuit 430', which is a variation of the detection circuit 430 described in the foregoing. The difference to the detection circuit 430 is that in the detection circuit 430' one of the MOSFETs T11, T12 is arranged permanently in the non-conductive state. In the circuit arrangement 400' such coupling is shown for the MOSFET T11 having its gate connected to its source, thereby continuously keeping the MOSFET T11 in the non-conductive state. In a variation of the arrangement illustrated in Figure 9, the MOSFET T12 may be arranged permanently in the non-conductive state instead of the MOSFET T11. Consequently, only one of the MOSFETs T11 and T12 is arranged to receive the second control signal for switching into one of the conductive or non-conductive state once per half-wave while the other one of them is permanently in the non-conductive state. Nevertheless, the performance of the circuit arrangement 400' is basically similar to that of the circuit arrangement 400, since the one of the MOSFETs T11, T12 kept in the conductive state allows the flow of electric current in both directions (i.e. towards the node N and towards the node L) essentially equally well.

Also the switching operation of the MOSFETS T1, T2 and one of the MOSFETS T11 and T12 applied in context of the circuit arrangement 400' is substantially similar to that applied in context of the circuit arrangement 400. The primary difference is that due to one of the MOSFETs T11, T12 being arranged to permanently operate in the non-conductive state, only one second control signal is required for switching the other one of the MOSFETs T11, T12, thereby simplifying the structure of the circuit arrangement.

The operations, procedures and/or functions described in the foregoing in context of the circuit arrangements 400 and 400' and/or in context of the current detection circuits 430 and 430' may be provided as a method for operating the circuit arrangement 400, 400' and/or the detection circuit 430, 430'. Such method may comprise issuing the first and second control signals, e.g. by the control portion or the control entity, to control operation of the circuit arrangement 400, 400' as described in the foregoing.

Reference(s) to a processor or a microprocessor should not be understood to encompass only programmable processors, but also dedicated circuits such as field-programmable gate arrays (FPGA), application specific circuits (ASIC), signal processors, etc. Features described in the preceding description may be used in combinations other than the combinations explicitly described. Although functions have been described with reference to certain features, those functions may be performable by other features whether described or not. Although features have been described with reference to certain embodiments, those features may also be present in other embodiments whether described or not.

## Claims

1. A circuit (400, 400') for providing a leading edge type phase-cut alternating current, AC, to a load (120, 220, 320), the circuit comprising
a current path for coupling a load (120, 220, 320) to an input AC supply,
at least one primary switch (T1, T2) arranged in said current path for implementing leading edge type phase-cutting of the input AC, the at least one primary switch (T1, T2) arranged to operate alternatingly in one of a conductive and a non-conductive state in accordance with at least one first control signal, and
a detection circuit (430, 430') arranged in said current path, arranged to provide a zero current detection signal for indicating the end of a half-wave in said phase-cut AC, wherein said detection circuit (430, 430') comprises two parallel branches, and
a first MOSFET (T11) arranged in a first branch of said two parallel branches and a second MOSFET (T12) in a second branch of said two parallel branches such that the direction of the current path from the source to the drain through the first MOSFET (T11) is opposite to that of the second MOSFET (T12),
wherein one or both of the first MOSFET (T11) and the second MOSFET (T12) are arranged to receive respective second control signals for switching into one of a conductive state and a non-conductive state, wherein said switching into non-conductive state is made by a predefined margin before the end of the half-wave of said phase-cut AC.

2. A circuit according to claim 1,
wherein exactly one of the first MOSFET (T11) and second MOSFET (T12) of the detection circuit (430, 430') is arranged to receive a second control signal for switching it into one of the conductive state and the non-conductive state, and
wherein the other one of the first (T11) and second (T12) MOSFETs of the detection circuit (430, 430') is arranged permanently in the non-conductive state.

3. A circuit according to claim 1 or 2, wherein said at least one primary switch (T1, T2) comprises a first primary MOSFET (T1) and a second primary MOSFET (T2) arranged in said current path such that the direction of the current path from the source to the drain through the first primary MOSFET (T1) is opposite to that of the second primary MOSFET (T2).

4. A circuit according to any of claims 1 to 3, further comprising a control portion arranged to issue said first and second control signals, and
a zero current detection circuit comprising a differential amplifier (IC1) having its inputs coupled to both sides of the detection circuit (430, 430') for generation of a zero-current indication signal at the output of the differential amplifier (IC1) for provision to said control portion so as to indicate the end of a half-wave in said phase-cut AC.

5. A circuit according to claim 4, wherein the control portion is arranged to issue said first control signal to cause switching said at least one primary switch (T1, T2) into the conductive state starting from a predetermined point of time during a half-wave of the input AC and to cause switching said at least one primary switch (T1, T2) into the non-conductive state in response to said zero-current indication, and
issue at least one second control signal to cause said switching of at least one of the first and second MOSFETs (T11, T12) of the detection circuit (430, 430') into the conductive state starting from said predetermined point of time and to cause said switching of said at least one of the first and second MOSFETs (T11, T12) of the detection (430, 430') circuit into the non-conductive state by a predefined margin before the end of said half-wave of said phase-cut AC.

6. A circuit according to claim 5, wherein the control portion is arranged to issue said at least one second control signal to cause said switching of said at least one of the first and second MOSFETs (T11, T12) of the detection circuit (430, 430') into the non-conductive state in response to detecting a voltage across the poles of the input AC to have an absolute value that is smaller than or equal to a predetermined reference voltage.

7. A circuit according to claim 6, wherein said predetermined reference voltage is zero.

8. A circuit according to any of claims 1 to 7, wherein said circuit is arranged to operate as a dimming circuit for a dimmable light source (220, 320).

9. A lighting arrangement comprising
a circuit according claim 8, and
a lighting device (320) comprising one or more light emitting diodes (322) arranged to operate as said dimmable light source.

## Patentansprüche

1. Schaltung (400, 400') zum Bereitstellen eines Wechselstroms, AC, mit Phasenanschnitt an der Vorderflanke an eine Last (120, 220, 320), wobei die Schaltung umfasst:
einen Strompfad zum Koppeln einer Last (120, 220, 320) an eine Eingangs-AC-Quelle,
wenigstens einen Primärschalter (T1, T2), der im Strompfad angeordnet ist, um den Phasenanschnitt an der Vorderflanke des Eingangs-AC zu realisieren, wobei der wenigstens eine Primärschalter (T1, T2) dafür ausgelegt ist, abwechselnd in einem leitenden und einem nichtleitenden Zustand entsprechend wenigstens einem ersten Steuersignal betrieben zu werden, und
eine Detektionsschaltung (430, 430'), die im Strompfad angeordnet ist und dafür ausgelegt ist, ein Nullstromdetektionssignal bereitzustellen, um das Ende einer Halbwelle im Phasenanschnitt-AC anzuzeigen, wobei die Detektionsschaltung (430, 430') umfasst:
zwei parallele Zweige, und
einen ersten MOSFET (T11), der in einem ersten Zweig der beiden parallelen Zweige angeordnet ist, und einen zweiten MOSFET (T12) in einem zweiten Zweig der beiden parallelen Zweige derart, dass die Richtung des Strompfads vom Source-Anschluss zum Drain-Anschluss des ersten MOSFET (T11) derjenigen des zweiten MOSFET (T12) entgegengesetzt ist,
wobei der erste MOSFET (T11) und/oder der zweite MOSFET (T12) dafür ausgelegt sind, jeweilige zweite Steuersignale zu empfangen, um entweder in einen leitenden Zustand oder in einen nichtleitenden Zustand zu schalten, wobei das Schalten in den nichtleitenden Zustand bis zu einer vorbestimmten Marge vor dem Ende der Halbwelle des Phasenanschnitt-AC ausgeführt wird.

2. Schaltung gemäß Anspruch 1,
wobei exakt entweder der erste MOSFET (T11) oder der zweite MOSFET (T12) der Detektionsschaltung (430, 430') dafür ausgelegt ist, ein zweites Steuersignal zu empfangen, um ihn entweder in den leitenden Zustand oder in den nichtleitenden Zustand zu schalten, und wobei der jeweils andere von dem ersten (T11) und dem zweiten (T12) MOSFET der Detektionsschaltung (430, 430') dafür ausgelegt ist, dauerhaft im nichtleitenden Zustand zu sein.

3. Schaltung gemäß Anspruch 1 oder 2, wobei der wenigstens eine Primärschalter (T1, T2) einen ersten primären MOSFET (T1) und einen zweiten primären MOSFET (T2) umfasst, die im Strompfad derart angeordnet sind, dass die Richtung des Strompfads vom Source-Anschluss zum Drain-Anschluss des ersten primären MOSFET (T1) derjenigen des zweiten primären MOSFET (T2) entgegengesetzt ist.

4. Schaltung gemäß einem der Ansprüche 1 bis 3, ferner umfassend:
einen Steuerabschnitt, der dafür ausgelegt ist, das erste und das zweite Steuersignal auszugeben, und
eine Nullstromdetektionsschaltung, umfassend einen differentiellen Verstärker (IC1), dessen Eingänge an die beiden Seiten der Detektionsschaltung (430, 430') gekoppelt sind zur Erzeugung eines Nullstromanzeigesignals am Ausgang des differentiellen Verstärkers (IC1) für die Bereitstellung an den Steuerabschnitt, um so das Ende einer Halbwelle des Phasenanschnitt-AC anzuzeigen.

5. Schaltung gemäß Anspruch 4, wobei der Steuerabschnitt dafür ausgelegt ist,
das erste Steuersignal auszugeben, um das Schalten des wenigstens einen Primärschalters (T1, T2) in den leitenden Zustand beginnend bei einem vorbestimmten Zeitpunkt während einer Halbwelle des Eingangs-AC zu bewirken und das Schalten des wenigstens einen Primärschalters (T1, T2) in den nichtleitenden Zustand in Reaktion auf die Nullstromanzeige zu bewirken, und wenigstens ein zweites Steuersignal auszugeben, um das Schalten wenigstens des ersten und/oder zweiten MOSFET (T11, T12) der Detektionsschaltung (430, 430') in den leitenden Zustand beginnend bei dem vorbestimmten Zeitpunkt zu bewirken und das Umschalten wenigstens des ersten und/oder zweiten MOSFET (T11, T12) der Detektionsschaltung (430, 430') in den nichtleitenden Zustand bis zu einer vorbestimmten Marge vor dem Ende der Halbwelle des Phasenanschnitt-AC zu bewirken.

6. Schaltung gemäß Anspruch 5, wobei der Steuerabschnitt dafür ausgelegt ist, das wenigstens eine zweite Steuersignal auszugeben, um das Schalten wenigstens des ersten und/oder des zweiten MOSFET (T11, T12) der Detektionsschaltung (430, 430') in den nichtleitenden Zustand zu bewirken, in Reaktion auf das Detektieren, dass eine Spannung über die Pole des Eingangs-AC einen absoluten Wert kleiner oder gleich einer vorbestimmten Bezugsspannung hat.

7. Schaltung gemäß Anspruch 6, wobei die vorbestimmte Bezugsspannung Null ist.

8. Schaltung gemäß einem der Ansprüche 1 bis 7, wobei die Schaltung dafür ausgelegt ist, als Dimmerschaltung für eine dimmbare Lichtquelle (220, 320) zu dienen.

9. Beleuchtungsanordnung, umfassend:
eine Schaltung gemäß Anspruch 8, und
eine Beleuchtungsvorrichtung (320), die eine oder mehrere Leuchtdioden (Light Emitting Diodes) (322) umfasst, welche dafür ausgelegt sind, als die dimmbare Lichtquelle betrieben zu werden.

## Revendications

1. Circuit (400, 400') destiné à fournir un courant alternatif, C.A., à coupure de phase sur front montant, à une charge (120, 220, 320), le circuit comprenant
un chemin de courant pour coupler une charge (120, 220, 320) à une alimentation C.A. d'entrée,
au moins un commutateur principal (T1, T2) agencé dans ledit chemin de courant pour mettre en oeuvre une coupure de phase sur front montant du C.A. d'entrée, l'au moins un commutateur principal (T1, T2) étant agencé pour fonctionner alternativement dans l'un d'un état conducteur et d'un état non conducteur conformément à au moins un premier signal de commande, et
un circuit de détection (430, 430') agencé dans ledit chemin de courant, agencé pour fournir un signal de détection de courant nul servant à indiquer la fin d'une demi-onde dans ledit C.A. à coupure de phase, dans lequel ledit circuit de détection (430, 430') comprend
deux branches parallèles, et
un premier MOSFET (T11) agencé dans une première branche desdites deux branches parallèles et un second MOSFET (T12) dans une seconde branche desdites deux branches parallèles de telle sorte que le sens du chemin de courant depuis la source jusqu'au drain à travers le premier MOSFET (T11) soit opposé à celui du second MOSFET (T12),
dans lequel l'un du premier MOSFET (T11) et du second MOSFET (T12) ou les deux sont agencés pour recevoir des seconds signaux de commande respectifs servant à commuter sur l'un d'un état conducteur et d'un état non conducteur, dans lequel ladite commutation sur ledit état non conducteur est réalisée par une marge prédéfinie avant la fin de la demi-onde dudit C.A. à coupure de phase.

2. Circuit selon la revendication 1,
dans lequel exactement l'un du premier MOSFET (T11) et du second MOSFET (T12) du circuit de détection (430, 430') est agencé pour recevoir un second signal de commande afin de le commuter sur l'un de l'état conducteur et de l'état non conducteur, et
dans lequel l'autre du premier (T11) et du second (T12) MOSFET du circuit de détection (430, 430') est agencé en permanence sur l'état non conducteur.

3. Circuit selon la revendication 1 ou 2, dans lequel ledit au moins un commutateur principal (T1, T2) comprend un premier MOSFET (T1) principal et un second MOSFET (T2) principal agencés dans ledit chemin de courant de telle sorte que le sens du chemin de courant depuis la source jusqu'au drain à travers le premier MOSFET (T1) soit opposé à celui du second MOSFET (T2).

4. Circuit selon l'une quelconque des revendications 1 à 3, comprenant en outre
une partie de commande agencée pour émettre lesdits premier et second signaux de commande, et un circuit de détection de courant nul comprenant un amplificateur différentiel (IC1) dont les entrées sont couplées aux deux côtés du circuit de détection (430, 430') pour la génération d'un signal d'indication de courant nul à la sortie de l'amplificateur différentiel (IC1) destiné à être fourni à ladite partie de commande de manière à indiquer la fin d'une demi-onde dans ledit C.A. à coupure de phase.

5. Circuit selon la revendication 4, dans lequel la partie de commande est agencée pour émettre ledit premier signal de commande de manière à entraîner la commutation dudit au moins un commutateur principal (T1, T2) sur l'état conducteur à partir d'un point prédéterminé dans le temps durant une demi-onde du C.A. d'entrée et à entraîner la commutation dudit au moins un commutateur principal (T1, T2) sur l'état non conducteur en réponse à ladite indication de courant nul, et
émettre au moins un second signal de commande de manière à entraîner la commutation d'au moins l'un des premier et second MOSFET (T11, T12) du circuit de détection (430, 430') sur l'état conducteur à partir d'un point prédéterminé dans le temps et à entraîner ladite commutation d'au moins l'un desdits premier et second MOSFET (T11, T12) du circuit de détection (430, 430') sur l'état non conducteur par une marge prédéfinie avant la fin de ladite demi-onde dudit C.A. à coupure de phase.

6. Circuit selon la revendication 5, dans lequel la partie de commande est agencée pour émettre ledit au moins un second signal de commande de manière à entraîner la commutation dudit au moins un des premier et second MOSFET (T11, T12) du circuit de détection (430, 430') sur l'état non conducteur en réponse à la détection d'une tension aux bornes des pôles du CA d'entrée d'une valeur absolue inférieure ou égale à une tension de référence prédéterminée.

7. Circuit selon la revendication 6, dans lequel ladite tension de référence prédéterminée est nulle.

8. Circuit selon l'une quelconque des revendications 1 à 7, dans lequel ledit circuit est agencé pour fonctionner en tant que circuit variateur d'une source de lumière modulable (220, 320).

9. Agencement d'éclairage comprenant
un circuit selon la revendication 8, et
un dispositif d'éclairage (320) comprenant une ou plusieurs diodes électroluminescentes (322) agencées pour fonctionner en tant que dite source de lumière modulable.
